# EUROPEAN PATENT APPLICATION

(11) **EP 2 429 005 A2**
(43) Date of publication of application: **14.03.2012**
(21) Application number: 11180978.6
(22) Date of filing: 12.09.2011
(51) Int. Cl.: H01L 31/18

(54) **Method for manufacturing a mono-crystalline silicon solar cell and etching method thereof**

(30) Priority: 14.09.2010 TW 099130966
(71) Applicant: Wakom Semiconductor Corporation, Hsinchu County 303 (TW)
(72) Inventor: Chien, Ray, 303 Hsinchu County (TW); Lin, Yu-Mei, 303 Hsinchu County (TW); Kao, Wei-Che, 303 Hsinchu County (TW); Chiang, I-Ling, 303 Hsinchu County (TW)
(74) Representative: Lang, Christian

(57) **Abstract**

In order to texture the surfaces of the mono-crystalline silicon wafer solar cells, an etching step of the method for manufacturing a mono-crystalline silicon wafer solar cell is provided which comprises a step of etching at least one surface of a mono-crystalline silicon wafer with an alkaline etching solution that containing silver metal ions. Since the silver metal ions are catalytic in function for the increase of the silicon etching rate in the alkaline etching solution, the process time for the texturization of a mono-crystalline silicon wafer is reduced.

## Description

### BACKGROUND OF THE INVENTION

### (a) Field of the Invention

The present invention relates to a novel method for manufacturing a mono-crystalline or a quasi-mono-crystalline silicon solar cell and a wet etching method thereof. It relates in particular to a method for manufacturing a mono-crystalline or a quasi-mono-crystalline silicon solar cell and a wet etching method thereof which can increase the production rate.

### (b) Description of the Related Art

Solar cells are the devices that convert light energy into electrical energy, and they may be categorized as the thin-film solar cells and the crystalline solar cells. Major materials presently used for crystalline solar cells in the market include silicon, and the crystalline silicon solar cells can be further sorted into mono-crystalline silicon solar cells, quasi-mono-crystalline silicon solar cells and multi-crystalline silicon solar cells. A quasi-mono-crystalline silicon wafer refers to a silicon wafer containing a mono-crystalline phase and many multi-crystalline phases, with the majority of the wafer being in a mono-crystalline phase. For simplicity in the following paragraphs, the word "mono-crystalline" may refer to both mono-crystalline and quasi-mono-crystalline as well.

A manufacturing process of p-type crystalline silicon solar cells includes a surface texturization (texture etching) step, a phosphorus diffusion step, a step for removing a surface oxide layer, a step for forming an anti-reflective layer, a step for forming electrodes, a laser-ablation edge isolation step. Another manufacturing process thereof includes a surface texturization (texture etching) step, a phosphorus diffusion step, a wet etching edge isolation step, a step for removing a surface oxide layer, a step for forming an anti-reflective layer, a step for forming electrodes.

In the surface texturization step, a surface of a silicon wafer is wet etched by using acidic or alkaline solution. The acidic solution suitable for etching multi-crystalline silicon solar cells typically contains a mixture of hydrofluoric acid and nitric acid, and the alkaline solution suitable for etching mono-crystalline silicon solar cells typically contains a mixture of sodium hydroxide or potassium hydroxide, and at least a kind of alcohol. However, for the mono-crystalline silicon wafers, the wet etching time is usually 20 minutes to 30 minutes for the surface texturization step according to prior art alkaline etching techniques. The silicon etching rate in the alkaline solution can be further increased to improve production throughput.

### BRIEF SUMMARY OF THE INVENTION

In an embodiment, an object of the invention is to provide a method for manufacturing a mono-crystalline silicon solar cell and a wet etching method thereof which increase the production rate of mono-crystalline silicon solar cells. In another embodiment, another object of the invention is to provide a method for manufacturing a mono-crystalline silicon solar cell and a wet etching method thereof which increase the silicon etching rate of the alkaline etching solution.

According to an embodiment of the invention, a wet etching method applied in a method for manufacturing a mono-crystalline silicon solar cell is provided. The wet etching method comprises a step of etching at least a surface of a mono-crystalline silicon wafer by using an alkaline solution. The alkaline solution contains an alkaline compound containing at least one compound selected from a group consisting of sodium hydroxide and potassium hydroxide, an alcohol compound, and a compound for releasing in the alkaline solution noble metal ions containing at least one ion selected from a group consisting of gold ions, silver ions, platinum ions, and palladium ions.

According to an embodiment of the invention, a method for manufacturing a mono-crystalline silicon solar cell is provided. The method comprises: etching at least a surface of a first-type mono-crystalline silicon wafer by using an alkaline solution; doping second-type impurities into the first-type mono-crystalline silicon wafer, so as to form a first-type area, a second-type area, and a junction between the first-type area and the second-type area; processing the edges of the first-type mono-crystalline silicon wafer so that there is substantially no short circuit between the edges of the first-type area and the second-type area; etching the surfaces of the mono-crystalline silicon wafer to remove a phosphosilicate glass (PSG) structure on the surfaces; forming an anti-reflective layer on the first-type mono-crystalline silicon wafer; and forming an electrode structure on the first-type mono-crystalline silicon wafer so that the first-type area and the second-type area form a current loop via an external electrical load. The alkaline solution contains an alkaline compound containing at least one compound selected from a group consisting sodium hydroxide and potassium hydroxide, an alcohol compound, and a compound for releasing in the alkaline solution noble metal ions containing at least one ion selected from a group consisting of gold ions, silver ions, platinum ions, and palladium ions.

In an embodiment of the invention, the noble metal ions may be gold ions, silver ions, platinum ions, palladium ions or the combination thereof. When the noble metal ions is silver ions, the compound for releasing silver ions in the alkaline solution may contain at least one compound selected from a group consisting of AgClO₄ and AgNO₃. In one embodiment, the compound for releasing silver ions in the alkaline solution may contain at least one compound selected from a group consisting of AgClO₃, AgC₂H₃O₂, AgMnO₄ and Ag₂SO₄.

In an embodiment, the alkaline compound is the potassium hydroxide, and the additive amount of the potassium hydroxide is approximately 1% to 4% by weight. The alcohol compound is an isopropanol (Isopropyl alcohol, abbreviated as IPA), and the additive amount of the isopropanol is approximately 2% to 6% by volume. When the compound for releasing silver ions in the alkaline solution contains at least one compound selected from a group consisting of AgClO₄ and AgNO₃, the additive amount of the silver compounds is approximately 1 ppm to 100 ppm by weight. When the compound for releasing silver ions in the alkaline solution contains at least one compound selected from a group consisting of AgClO₃, AgC₂H₃0₂, AgMnO₄ and Ag₂SO₄, the additive amount of the silver compounds is approximately 30 ppm to 5000 ppm by weight.

According to an embodiment of the present invention, since the alkaline solution contains the ions of the above-mentioned four predetermined noble metals, which catalyze the silicon etching by the alkaline compound, and the etching rate in the etching step is effectively increased. As a result, it takes less time to manufacture a mono-crystalline silicon solar cell, and then the productivity of mono-crystalline silicon solar cells is increased.

Other objectives, features and advantages of the present invention will be further understood from the further technological features disclosed by the embodiments of the present invention wherein there are shown and described preferred embodiments of this invention, simply by way of illustration of modes best suited to carry out the invention.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein:

FIGS. 1A~1G respectively show a schematic cross-section diagram of each step of a method for manufacturing a mono-crystalline silicon solar cell according to an embodiment of the present invention.

FIGS. 2A~2B show a flowchart of a method for manufacturing a mono-crystalline silicon solar cell according to an embodiment of the present invention.

### DETAILED DESCRIPTION OF THE INVENTION

In the following detailed description of the preferred embodiments, reference is made to the accompanying drawings which form a part hereof, and in which is shown by way of illustrating specific embodiments in which the invention may be practiced. In this regard, directional terminology is used with reference to the orientation of the Figure(s) being described. The components of the present invention can be positioned in a number of different orientations. As such, the directional terminology is used for purposes of illustration and is in no way limiting the scope of the present invention. On the other hand, the drawings are only schematic and the sizes of components may be exaggerated for clarity. It is to be understood that other embodiments may be employed and structural changes may be made without departing from the scope of the present invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," and variations thereof herein are used broadly and encompass direct and indirect connections, couplings, and mountings. Similarly, "adjacent to" and variations thereof herein are used broadly and encompass directly and indirectly "adjacent to". Therefore, the description of "A" component "adjacent to" "B" component herein may contain the situations that "A" component is directly "adjacent to" "B" component or one or more additional components is between "A" component and "B" component. Accordingly, the drawings and descriptions will be regarded as illustrative in nature and not as restrictive.

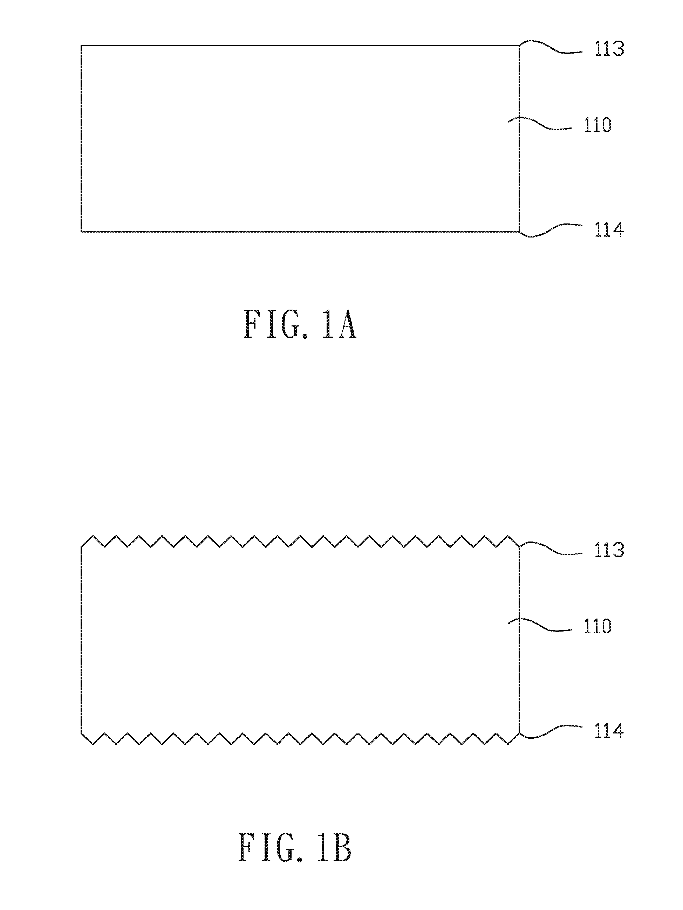

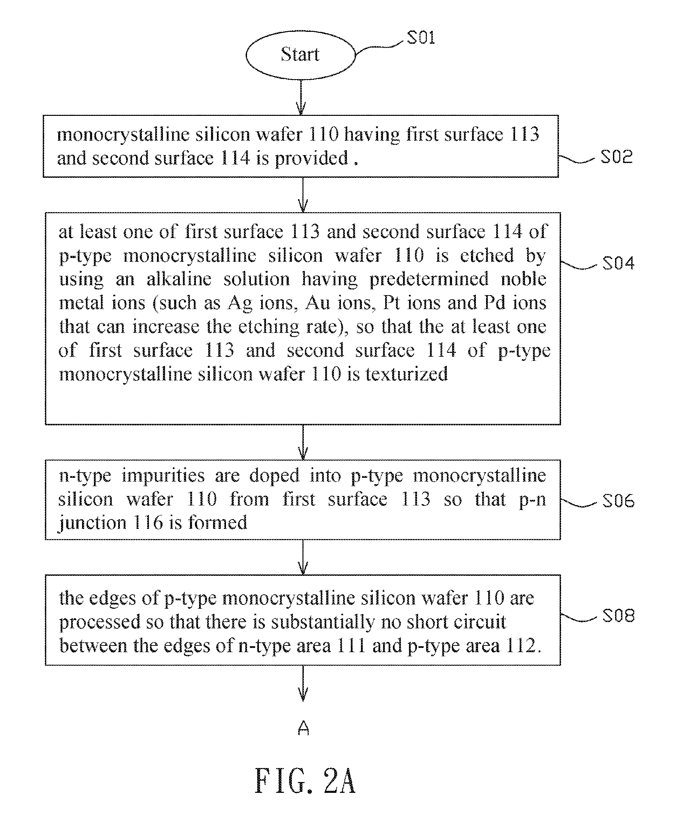

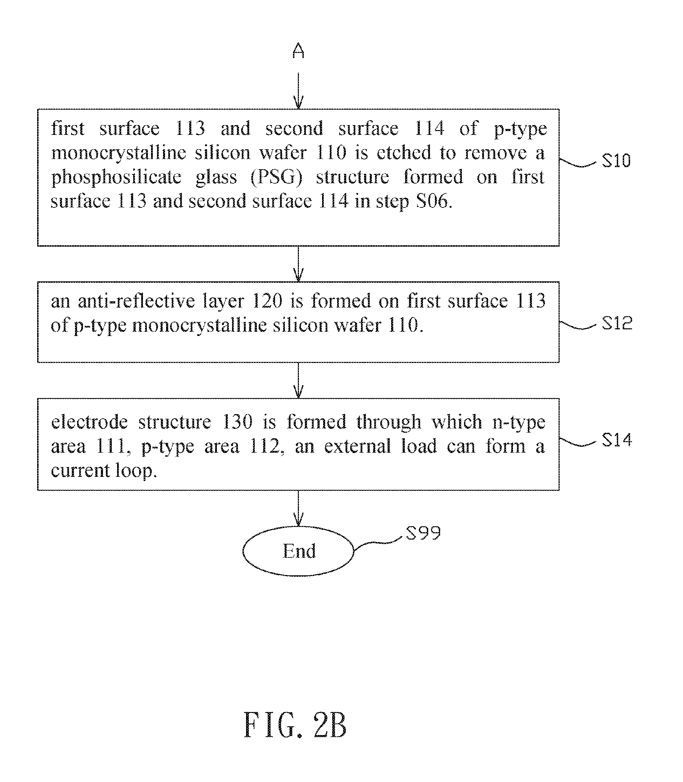

FIGS. 1A~1G respectively show a schematic cross-section diagram of each step of a method for manufacturing a mono-crystalline silicon solar cell according to an embodiment of the present invention. FIGS. 2A~2B show a flowchart of a method for manufacturing a mono-crystalline silicon solar cell according to an embodiment of the present invention. As shown in FIGS. 1A~1G and FIGS. 2A-2B, the method for manufacturing a mono-crystalline silicon solar cell comprises the following steps.

Step S01: start.

As shown in FIG. 1A, step S02: mono-crystalline silicon wafer 110 having first surface 113 and second surface 114 is provided. In this embodiment, mono-crystalline silicon wafer 110 may be a p-type mono-crystalline silicon wafer.

As shown in FIG. 1B, step S04 as a etching step: at least one of first surface 113 and second surface 114 of p-type mono-crystalline silicon wafer 110 is etched by using an alkaline solution having predetermined noble metal ions (such as Ag ions, Au ions, Pt ions and Pd ions that can increase the etching rate), so that the at least one of first surface 113 and second surface 114 of p-type mono-crystalline silicon wafer 110 is textured. This surface texture can lower the reflectivity of incident sunlight and/or remove the saw damage generated during manufacture of p-type mono-crystalline silicon wafer 110. In this embodiment, the alkaline solution may be an aqueous solution containing sodium hydroxide, potassium hydroxide or the combination thereof. Since the predetermined noble metal ions such as Ag ions, Au ions, Pt ions and Pd ions are further added into the alkaline solution, the etching in the etching step is effectively catalyzed and the etching rate increased. As a result, it takes less time to manufacture mono-crystalline silicon solar cell 100, and then the production throughput of mono-crystalline silicon solar cells 100 is increased.

The above-mentioned predetermined noble metal ions may be gold ions, silver ions, platinum ions, palladium ions or the combination thereof, preferably the silver ions.

In one embodiment, the alkaline solution may contain an alkaline compound, an alcohol compound, and a compound for releasing the predetermined noble metal ions in the alkaline solution. In one embodiment, the alkaline compound contains sodium hydroxide, potassium hydroxide or the combination thereof. The alcohol compound may include ethanol, propanol, isopropanol ((Isopropyl alcohol, abbreviated as IPA), or alcohols having higher molecular weight. When the alkaline solution contains silver ions, the compound for releasing silver ions in the alkaline solution may be at least one compound selected from a group consisting of AgClO₄ and AgNO₃. In one embodiment, the compound for releasing silver ions in the alkaline solution may be at least one compound selected from a group consisting of AgClO₃, AgC2H₃O₂, AgMnO₄ and Ag₂SO₄. Note that the invention is not limited to the compound for releasing silver ions in the alkaline solution, and the person having ordinary skill in the art can choose proper compounds on the basis of the above description so as to make the alkaline solution containing gold ions, silver ions, platinum ions, palladium ions or the combination thereof.

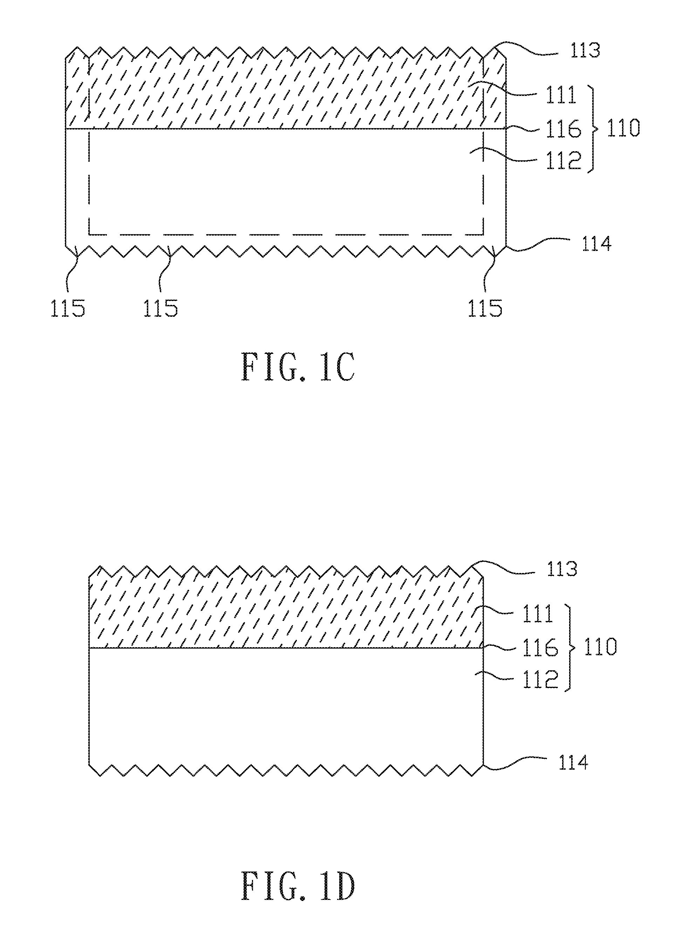

As shown in FIG. 1C, step S06 as a p-n junction formation step: n-type impurities are doped into p-type mono-crystalline silicon wafer 110 from first surface 113 so that p-n junction 116 is formed. In one embodiment, n-type impurities are doped into p-type mono-crystalline silicon wafer 110 to form a n-type impurity diffusion area by using thermal diffusion (in a furnace), printing, coating or spraying, so that p-type mono-crystalline silicon wafer 110 has n-type area 111, p-type area 112 and p-n junction 116 between n-type area 111 and p-type area 112. The n-type impurities may be phosphorus impurities which are doped into p-type mono-crystalline silicon wafer 110 in a furnace by using POCl₃ at a temperature of approximately 800°C to 820°C. In addition, if step S06 is performed in a furnace by using thermal diffusion, n-type parasitic structure 115 is also formed at the side surface and second surface 114 of p-type mono-crystalline silicon wafer 110.

As shown in FIG. 1D, step S08 as a edge isolation step: the edges of p-type mono-crystalline silicon wafer 110 are processed so that there is substantially no short circuit between the edges of n-type area 111 and p-type area 112. In one embodiment, the edge isolation step is performed by using wet etching after the p-n junction formation step and before the below-mentioned step for removing a surface oxide layer. Specifically, n-type parasitic structure 115 at the side surface and second surface 114 of p-type mono-crystalline silicon wafer 110 is removed by using a mixture of HNO₃ acid and HF acid, so that mono-crystalline silicon solar cell 100 has no current passing through n-type parasitic structure 115 and then has no short circuit on the edges. In one embodiment, the edge isolation step is performed by using laser ablation after the below-mentioned electrode formation step (step S 14). Specifically, a separating groove for separating the edges of n-type area 111 and p-type area 112 is formed by laser ablation so that mono-crystalline silicon solar cell 100 has no current passing through n-type parasitic structure 115 and then has no short circuit on the edges.

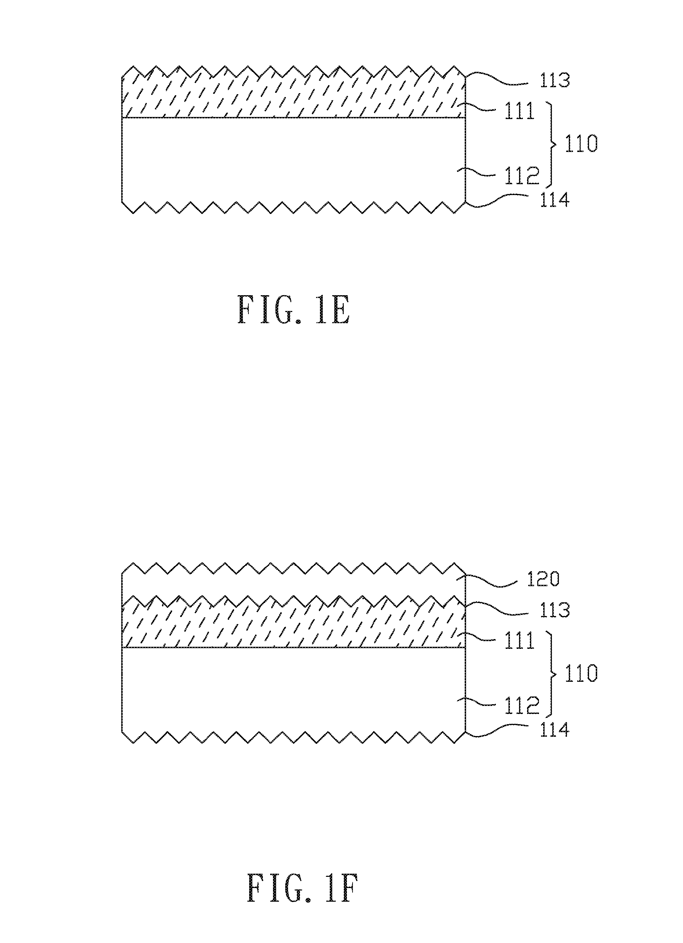

As shown in FIG. 1E, step S 10 as a step for removing a surface oxide layer: first surface 113 and second surface 114 of p-type mono-crystalline silicon wafer 110 is etched to remove a phosphosilicate glass (PSG) structure (not shown) formed on first surface 113 and second surface 114 in step S06.

As shown in FIG. 1F, step S 12: an anti-reflective layer 120 is formed on first surface 113 of p-type mono-crystalline silicon wafer 110.

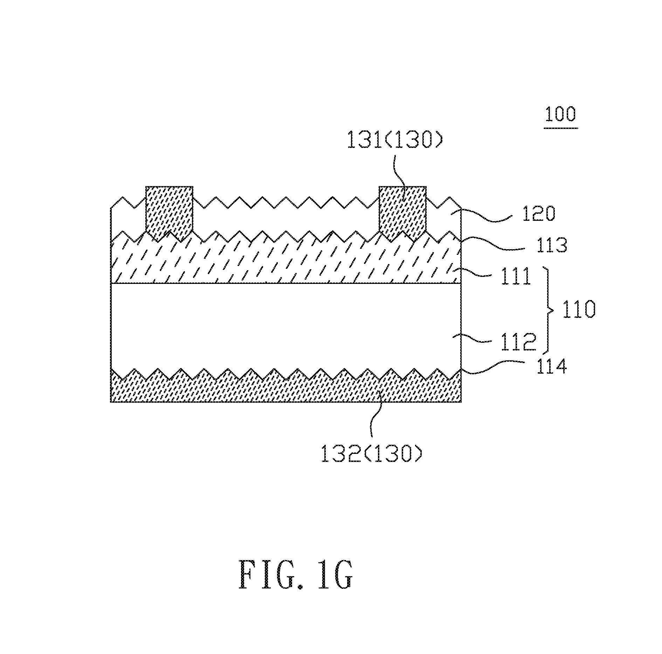

As shown in FIG. 1G, step S14: electrode structure 130 is formed through which n-type area 111, p-type area 112, an external load (not shown) can form a current loop, so that mono-crystalline silicon solar cell 100 according to an embodiment of the present invention is completed. Specifically, electrode structure 130 includes first electrode 131 and second electrode 132, and first electrode 131 and second electrode 132 are electrically coupled to each other via the external load so that n-type area 111, p-type area 112, the external load (not shown) can form a current loop.

Step S99: end.

In the examples according to the present invention, the alkaline solution respectively contains about 1% to about 4% by weight of potassium hydroxide, about 2% to about 6% by volume of isopropanol. In addition, about 1ppm to about 100ppm by weight of AgNO₃ is added into the alkaline solution. The alkaline solution is kept at a temperature between 75°C and 80°C in the wet etching step. Compared to a conventional example where the alkaline solution does not contain silver compound ionized in the solution, the wet etching rate in the etching step for surface texturization is effectively increased by 1 time to 2 times or more when about 1ppm to 100ppm of AgNO₃ (by weight) is added into the alkaline solution.

Even the alkaline solution containing silver compound ionized in the solution (or alkaline solution containing silver ions) is used in the example where the alkaline solution does not contain alcohol compound, the etching rate may also be increased. Please refer to the following examples. The alkaline solution respectively contains about 1% to about 4% by weight of potassium hydroxide. In addition, about 1ppm to 100ppm by weight of AgNO₃ is added into the alkaline solution. The alkaline solution is kept at a temperature between 75°C and 80°C in the etching step. Compared to a conventional example where the alkaline solution does not contain silver compound ionized in the solution, the wet etching rate in the etching step for silicon surface etching is effectively increased by 1 time to 1.5 times or more when about 1ppm to 100ppm by weight of AgNO₃ is added into the alkaline solution.

As above stated, the experimental results show that the wet etching rate is effectively increased if the alkaline solution containing silver ions is used in the wet etching step for surface texturization or for surface etching. When the additive amount of AgNO₃ exceeds 10 ppm by weight, the formation of suspended matter or precipitate of black AgO can be clearly observed in the alkaline solution. Therefore it is understood that the concentration of silver ions in the alkaline solution under the above-mentioned condition is less than 10 ppm by weight, because some of the Ag ions turn into AgO precipitates. Likewise, the formation of suspended matter or precipitate of black AgO can also be observed in the alkaline solution containing different additive amounts of AgNO₃. From the observation of black AgO precipitate by-product in the solution, it can be easily concluded that the amount of silver ions (number of Ag ions) in the alkaline solution is less than the amount of AgNO₃ (number of Ag atoms in AgNO₃) added into the liquid.

The etching rate increases with the increasing additive amount of AgNO₃ in the example where the additive amount is relatively small, for example under 30ppm by weight for a certain alkaline compound concentration. According to the experimental result of an example, when compared to the etching rate in a conventional example where the alkaline solution does not contain AgNO₃, the etching rate doubles after about 50ppm AgNO₃ (by weight) is added into the alkaline solution.

Since the cost of silver is quite high, and even so for the other three above-mentioned noble metals, too high an additive amount of AgNO₃ may significantly increase the manufacturing cost. In addition, the experimental results show that if the additive amount of AgNO₃ is excessive, for example when it exceeds 100 ppm (by weight) for certain alkaline compound concentration, the silicon etching rate decreases (from maximum) and the formation of suspended matter or precipitate by-product of black AgO will be also excessive. As a result, the quality of the surface texturization deteriorates, and the etching rate suffers. To avoid the above problems, the additive amount of AgNO₃ may be kept below 100 ppm by weight in a preferred embodiment. In consideration of both the alkaline etching rate and the quality of the surface texturization, it is preferably that the additive amount of AgNO₃ is between 10 ppm to 80 ppm by weight (under certain alkaline compound concentration and temperature).

There are many kinds of compounds for releasing silver ions in the alkaline solution, for example, AgC₂H₃O₂, AgN₃, AgBrO₃, AgBr, Ag₂CO₃, AgClO₃, AgCl, AgClO, Ag₂CrO₄, AgCN, Ag₂Cr₂O₇, AgF, AgNO₃, Ag₂C₂O₄, Ag₂O, AgCl0₄, AgMnO₄, Ag₂SO₄, AgVO₃. However, these sliver compounds respectively have different water solubility. In order to obtain better etching quality and etching result and cost reduction, the compound for releasing silver ions in the alkaline solution may contain at least one compound selected from a group consisting of AgClO₄, AgNO₃, AgClO₃, Ag₂SO₄, AgC₂H₃O₂, AgMnO₄ and Ag₂SO₄ in an example where the alkaline solution contains silver ions. Table 1 below provides information on the variation of water solubility of different silver compounds at a temperature of about 20° C, under 1 atm pressure, where the unit of water solubility is in g/100g H₂O.

**Table 1**

| Formula of Substance | solubility in g/100g H₂O |
|---|---|
| AgC₂H₃0₂ | 1.05 |
| AgMnO₄ | 0.9 |
| Ag₂SO₄ | 0.8 |
| AgClO₃ | 15.3 |
| AgNO₃ | 216 |
| AgClO₄ | 525 |

The compound selected from a group consisting of AgClO₄ and AgNO₃ has solubility in water larger than that of the compound selected from a group consisting of AgClO₃, AgC2H₃O₂, AgMnO₄ and Ag2SO₄. Therefore, using the compound selected from a group consisting of AgClO₄ and AgNO₃ can be more economical. AgC₂H₃O₂, AgMnO₄ and Ag₂SO₄ respectively have a water solubility at a temperature of about 20° C less than one percent of the water solubility of AgNO₃. As a result, in order to effectively increase the etching rate, the additive amount of the compound selected from a group consisting of AgClO₃, AgC₂H₃O₂, AgMnO₄ and Ag₂SO₄ may be adjusted to 30ppm to 5000ppm by weight. In contrast, the additive amount of the compound selected from a group consisting of AgClO₄ and AgNO₃ may be merely adjusted to 1ppm to 100ppm by weight to effectively increase the etching rate.

Another silver compound AgF in the alkaline solution may affect to the surface texturization of a mono-crystalline silicon wafer, it decreases the silicon etching rate. Consequently, AgF is not an effective and useful compound in the etching step in this invention. In addition, since AgClO₃ has a water solubility at a temperature of about 20° C less than one twentieth of the water solubility of AgNO₃, its additive amount should be increased in a proper proportion (by about 10 times to 20 times) to effectively catalyze and increase the etching rate.

According to an embodiment of the present invention, since the alkaline solution contains the ions of the above-mentioned four predetermined noble metals, the etching rate in the etching step is effectively catalyzed and increased. As a result, it takes less time to manufacture a mono-crystalline silicon solar cell, and then the productivity of mono-crystalline silicon solar cells is increased.

The aforementioned description of the preferred embodiment in this invention has been presented for purposes of illustration and description. It is not intended to be exhaustive or to limit the invention to the precise form or to exemplary embodiments disclosed. Accordingly, the aforementioned description should be regarded as illustrative rather than restrictive. Obviously, many modifications and variations will be apparent to practitioners skilled in this art. The embodiments are chosen and described in order to best explain the principles of the invention and its best mode for practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like is not necessary limited the claim scope to a specific embodiment, and the reference to particularly preferred exemplary embodiments of the invention does not imply a limitation on the invention, and no such limitation is to be inferred. The invention is limited only by the spirit and scope of the appended claims. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret or limit the scope or meaning of the claims. Any advantages and benefits described may not apply to all embodiments of the invention. It should be appreciated that variations may be made in the embodiments described by persons skilled in the art without departing from the scope of the present invention as defined by the following claims. Moreover, no element and component in the present disclosure is intended to be dedicated to the public regardless of whether the element or component is explicitly recited in the following claims.

## Claims

1. An etching method applied in a method for manufacturing a mono-crystalline silicon solar cell comprising:
etching at least a surface of a mono-crystalline silicon wafer by using an alkaline solution,
wherein the alkaline solution contains:
an alkaline compound containing at least one compound selected from a group consisting sodium hydroxide and potassium hydroxide,
an alcohol compound, and
a compound for releasing in the alkaline solution noble metal ions containing at least one ion selected from a group consisting of gold ions, silver ions, platinum ions, and palladium ions.

2. The etching method according to claim 1, wherein the alcohol compound containing at least one compound selected from a group consisting of ethanol, propanol, and isopropanol.

3. The etching method according to claim 1, wherein the compound for releasing in the alkaline solution noble metal ions is a silver compound.

4. The etching method according to claim 3, wherein the silver compound is a silver salt of an inorganic acid or a silver salt of an organic acid.

5. The etching method according to claim 3, wherein
the silver compound contains at least one compound selected from a group consisting of AgClO₃, AgC2H₃O₂, AgMnO₄ and Ag₂SO₄, and
the additive amount of the silver compound is approximately 30ppm to 5000ppm by weight.

6. The etching method according to claim 3, wherein the silver compound containing at least one compound selected from a group consisting of AgNO₃ and AgClO₄.

7. The etching method according to claim 6, wherein the additive amount of the silver compound is approximately 1ppm to 100ppm by weight.

8. The etching method according to claim 6, wherein
the alkaline compound is the potassium hydroxide, and the additive amount of the potassium hydroxide is approximately 1% to 4% by weight,
the alcohol compound is an isopropanol, the additive amount of the isopropanol is approximately 2% to 6% by volume,
the additive amount of the silver compound is approximately 1 ppm to 100ppm by weight.

9. A method for manufacturing a mono-crystalline silicon solar cell comprising:
etching at least a surface of a first-type mono-crystalline silicon wafer by using
an alkaline solution, wherein the alkaline solution contains:
an alkaline compound containing at least one compound selected from a group consisting sodium hydroxide and potassium hydroxide,
an alcohol compound, and
a compound for releasing in the alkaline solution noble metal ions containing at least one ion selected from a group consisting of gold ions, silver ions, platinum ions, and palladium ions;
doping second-type impurities into the first-type mono-crystalline silicon wafer, so as to form a first-type area, a second-type area, and a junction between the first-type area and the second-type area;
processing the edges of the first-type mono-crystalline silicon wafer so that there is substantially no short circuit between the edges of the first-type area and the second-type area;
etching the at least a surface of the mono-crystalline silicon wafer to removing a phosphosilicate glass structure on the at least a surface;
forming an anti-reflective layer on the first-type mono-crystalline silicon wafer; and
forming an electrode structure on the first-type mono-crystalline silicon wafer so that the first-type area and the second-type area form a current loop via an external load.

10. The method according to claim 9, wherein the compound for releasing in the alkaline solution noble metal ions is a silver compound.

11. The method according to claim 10, wherein the silver compound contains at least one compound selected from a group consisting of AgNO₃ and AgClO₄.

12. The method according to claim 11, wherein
the alkaline compound is the potassium hydroxide, and the additive amount of the potassium hydroxide is approximately 1% to 4% by weight,
the alcohol compound is an isopropanol, the additive amount of the isopropanol is approximately 2% to 6% by volume,
the additive amount of the silver compound is approximately 1 ppm to 100ppm by weight.

13. An etching method applied in a method for manufacturing a crystalline silicon solar cell comprising:
etching at least a surface of a crystalline silicon wafer by using an alkaline solution,
wherein the crystalline silicon wafer is selected from a group consisting of mono-crystalline silicon wafer and quasi-mono-crystalline silicon wafer, and
the alkaline solution contains:
an alkaline compound containing at least one compound selected from a group consisting sodium hydroxide and potassium hydroxide,
an alcohol compound, and
a compound for releasing in the alkaline solution noble metal ions containing at least one ion selected from a group consisting of gold ions, silver ions, platinum ions, and palladium ions.

14. The etching method according to claim 13, wherein the compound for releasing in the alkaline solution noble metal ions is a silver compound selected from a group consisting of AgNO₃, AgClO₄ and AgClO₃.

15. The method according to claim 13, wherein
the additive amount of the alkaline compound is approximately 1% to 4% by weight,
the additive amount of the alcohol compound is approximately 0.5% to 10% by volume,
the additive amount of the silver compound is approximately 1ppm to 1500ppm by weight.
